# EUROPEAN PATENT APPLICATION

(11) **EP 1 650 807 A2**
(43) Date of publication of application: **26.04.2006**
(21) Application number: 05022117.5
(22) Date of filing: 11.10.2005
(51) Int. Cl.: H01L 29/45, H01L 29/49, H01L 27/12, H01L 21/336, H01L 21/84

(54) **Thin film transistor, electro-optical device and electronic apparatus**

(30) Priority: 21.10.2004 JP 2004306607; 21.10.2004 JP 2004306608; 28.06.2005 JP 2005187724
(71) Applicant: SEIKO EPSON CORPORATION, Shinjuku-ku, Tokyo 163-0811 (JP)
(72) Inventor: Kobayashi, Yosuke Seiko Epson Corporation, Suwa-shi Nagano-ken 392-8502 (JP)
(74) Representative: HOFFMANN EITLE

(57) **Abstract**

A thin film transistor (60) includes a semiconductor layer formed over a substrate (P), and an electrode member formed over the substrate by a liquid phase method. The electrode member includes a base layer (67) composed of a metal material and an outer surface layer deposited on at least one surface of the base layer. The outer surface layer is formed of a metal material that is less susceptible to being dissolved in silicon and a silicon compound compared with the metal material constituting the base layer.

## Description

### BACKGROUND OF THE INVENTION

### 1. Technical Field

The present invention relates to a thin film transistor, an electro-optical device and an electronic apparatus.

### 2. Related Art

When manufacturing thin film transistors (TFTs), which are switching elements used in electro-optical devices such as liquid crystal devices, a photolithography method is used in steps of forming electrodes, wires or the like. The photolithography method is to form patterns of electrodes or wires composed of functional thin films through the following steps: a step of forming a blanket thin film by a film deposition method such as sputtering, plating or CVD, a step of applying a photosensitive material called resist on the thin film, a step of subjecting the resist to exposure and development, and a step of etching a conductive film according to the obtained resist pattern. In the forming and patterning of functional thin films employing the photolithography including a series of the steps, large-scale equipment such as an vacuum apparatus and complicated steps are required in the film deposition and etching treatment, and the efficiency of material use is about several percentages, i.e., most of the material should be wasted. Therefore, the photolithography involves disadvantages of high manufacturing costs and low productivity.

In contrast, a method has been proposed by which electrode patterns or wire patterns (thin film patterns) are formed on a substrate by using a droplet discharge method for discharging a liquid material in a droplet form from liquid discharge heads, so-called an ink jet method. For example, JP A-2003-317945 is an example of documents disclosing this related art. In this method, directly patterned on a substrate is ink for patterning thin films that is a liquid material including conductive fine particles such as metal fine particles or a precursor thereof dispersed therein, and then the applied liquid material is subjected to heat treatment or laser irradiation to thereby be converted into a conductive thin film pattern. This method eliminates the need for the complicated film deposition, photolithography and etching, which significantly simplifies processes. In addition, the method provides advantages of smaller use amount of a raw material and higher productivity.

In the technique described in the document example of the related art, banks according to thin film patterns to be formed are formed, and ink is discharged in regions surrounded by the banks. The discharged ink is dried and baked to obtain a thin film pattern. However, a process for applying this technique to fabrication of TFTs, which are composed of a multi-layer structure on a substrate, may cause problems. Specifically, the process includes a step of depositing different kinds of materials on a substrate to form a multi-layer structure, and a step of heating the deposited multi-layer structure. Therefore, this heating may cause diffusion of atoms of layers into the adjacent layers. More specifically, for example, a metal material used as a wire material for source-drain electrodes and gate electrodes of TFTs may diffuse into a semiconductor layer electrically coupled to the electrodes, which may vary characteristics of the TFTs.

### SUMMARY

An advantage of some aspects of the invention is to provide a thin film transistor with excellent operational reliability, formed by using a liquid phase method and allowing high yield manufacturing. Another advantage of the invention is to provide an electro-optical device having the thin film transistor and thus achieving excellent operational reliability.

A thin film transistor according to an aspect of the invention includes a semiconductor layer formed over a substrate, and an electrode member formed over the substrate by a liquid phase method. The electrode member includes a base layer composed of a metal material and an outer surface layer deposited on at least one surface of the base layer. The outer surface layer is formed of a metal material that is less susceptible to being dissolved in silicon and a silicon compound compared with the metal material constituting the base layer.

According to the configuration of the aspect of the invention, the outer surface layer can prevent the material constituting the base layer from diffusing into the adjacent silicon or silicon compound layer. Thus, performance degradation and variation of characteristics of the thin film transistor can be prevented. Therefore, the present configuration can provide a thin film transistor that achieves lowering of manufacturing costs thereof due to the formation of the electrode member by using a liquid phase method, and the improvement of its operational reliability.

A thin film transistor according to another aspect of the invention includes a semiconductor layer formed over a substrate, and an electrode member formed over the substrate. The electrode member has a structure in which a barrier layer and a base layer are sequentially deposited on top of each other by using a liquid phase method. The barrier layer is composed of a metal material. The base layer is composed of a metal material. The metal material constituting the barrier layer is at least one metal material selected from Ni, Ti, W and Mn.

According to the configuration, the barrier layer formed as a lower layer of the electrode member can prevent the material constituting the base layer from diffusing into the adjacent layer of the multi-layer structure of the thin film transistor. Thus, performance degradation and variation of characteristics of the thin film transistor can be prevented. Therefore, the present configuration can provide a thin film transistor that achieves lowering of manufacturing costs thereof due to the formation of the electrode member by using a liquid phase method, and the improvement of its operational reliability.

In the thin film transistor according to the aspect of the invention, it is preferable that the metal material constituting the base layer be at least one metal material selected from Ag, Cu and Al. Forming the base layer from any of these metal materials can reduce the electric resistance of the electrode member.

In the thin film transistor according to the aspect of the invention, it is preferable that part of the electrode member be a source electrode and a drain electrode that are electrically coupled to the semiconductor layer, and the source electrode and/or the drain electrode have a multi-layer structure of a barrier layer and the base layer. According to the configuration, the constitutional element of the base layer can be prevented from diffusing into the adjacent layer also in the source and drain electrodes. Typically the source electrode and/or the drain electrode are electrically coupled to the semiconductor layer of the TFT. The provision of the barrier layer can prevent the constitutional element of the base layer from diffusing into the semiconductor layer effectively, and thus a thin film transistor having excellent operational reliability can be obtained.

A thin film transistor according to another aspect of the invention includes a semiconductor layer formed over a substrate, and an electrode member formed over the substrate. The electrode member has a structure in which a base layer and a cover layer are sequentially deposited on top of each other by using a liquid phase method. The base layer is composed of a metal material. The cover layer is composed of a metal material. The metal material constituting the cover layer is at least one metal material selected from Ni, Ti, W and Mn.

According to the configuration, the cover layer formed as an upper layer of the electrode member can prevent the material constituting the base layer from diffusing into the adjacent layer of the multi-layer structure of the thin film transistor. Thus, performance degradation and variation of characteristics of the thin film transistor can be prevented. Therefore, the present configuration can provide a thin film transistor that achieves lowering of manufacturing costs thereof due to the formation of the electrode member by using a liquid phase method, and the improvement of its operational reliability.

In the thin film transistor according to the aspect of the invention, it is preferable that the metal material constituting the base layer be at least one metal material selected from Ag, Cu and Al. Forming the base layer from any of these metal materials can reduce the electric resistance of the electrode member.

It is preferable that the thin film transistor according to the aspect of the invention be a bottom-gate thin film transistor in which a gate electrode is formed between the semiconductor layer and the substrate. It is also preferable that the gate electrode have a multi-layer structure of the base layer and the cover layer. According to the configuration, the cover layer is disposed on a surface of the gate electrode facing the semiconductor layer. Therefore, the constitutional element of the base layer of the gate electrode can be prevented from diffusing into the semiconductor layer and a gate insulating film provided between the gate electrode and the semiconductor layer. Thus, performance degradation and so on of the thin film transistor can be prevented effectively.

In the thin film transistor according to the aspect of the invention, it is preferable that part of the electrode member be a source electrode and a drain electrode that are electrically coupled to the semiconductor layer, and the source electrode and/or the drain electrode have a multi-layer structure of the base layer and the cover layer.

According to the configuration, the constitutional element of the base layer can be prevented from diffusing into the adjacent layer also in the source and drain electrodes. When mounting the TFTs to an electronic device for example, provided adjacent to the TFTs are other constitutional members. However, the above configuration can prevent the constitutional elements of the electrode from diffusing into other constitutional members effectively, which significantly contributes to ensuring the operational reliability of the electronic device.

It is preferable that the thin film transistor according to the aspect of the invention be subjected to heat treatment at a temperature equal to or lower than 250° C at least after the semiconductor layer has been formed.

This heat treatment temperature can suppress dehydrogenation of the semiconductor layer due to the influence of the heat treatment, and thus rise of the on-resistance and lowering of the carrier mobility attributed to the dehydrogenation can be prevented. Therefore, a thin film transistor having excellent operational reliability can be manufactured.

An electro-optical device according to another aspect of the invention includes the above-described thin film transistor of the aspect of the invention. This configuration provides an electro-optical device that has a switching element with excellent operational reliability, and can be manufactured at low costs.

An electronic apparatus according to another aspect of the invention includes the above-described electro-optical device of the aspect of the invention. This configuration allows an electronic apparatus that has excellent reliability and can be provided at low costs.

### BRIEF DESCRIPTION OF THE DRAWINGS

The invention will be described with reference to the accompanying drawings, wherein like numbers refer to like elements, and wherein:

Fig. 1 is an equivalent circuit diagram of a liquid crystal display according to an embodiment of the invention.

Fig. 2 is a plan view illustrating the entire structure of the liquid crystal display according to the embodiment.

Fig. 3 is a plan view illustrating one pixel region of the liquid crystal display according to the embodiment.

Fig. 4 is a diagram illustrating part of the sectional structure of a TFT array substrate of the liquid crystal display according to the embodiment.

Fig. 5A is a diagram illustrating one example of a droplet discharge device.

Fig. 5B is a schematic diagram of a discharge head.

Figs. 6A to 6D are sectional views illustrating steps of a method of manufacturing a thin film transistor.

Figs. 7A to 7C are sectional views illustrating steps of the method of manufacturing a thin film transistor.

Figs. 8A to 8C are sectional views illustrating steps of the method of manufacturing a thin film transistor.

Figs. 9A to 9C are sectional views illustrating steps of the method of manufacturing a thin film transistor.

Figs. 10A to 10C are sectional views illustrating steps of the method of manufacturing a thin film transistor.

Fig. 11 is a schematic sectional view illustrating a Cap coating method.

Fig. 12 is a perspective view illustrating one example of electronic apparatuses.

### DESCRIPTION OF EXEMPLARY EMBODIMENTS

### Liquid Crystal Display

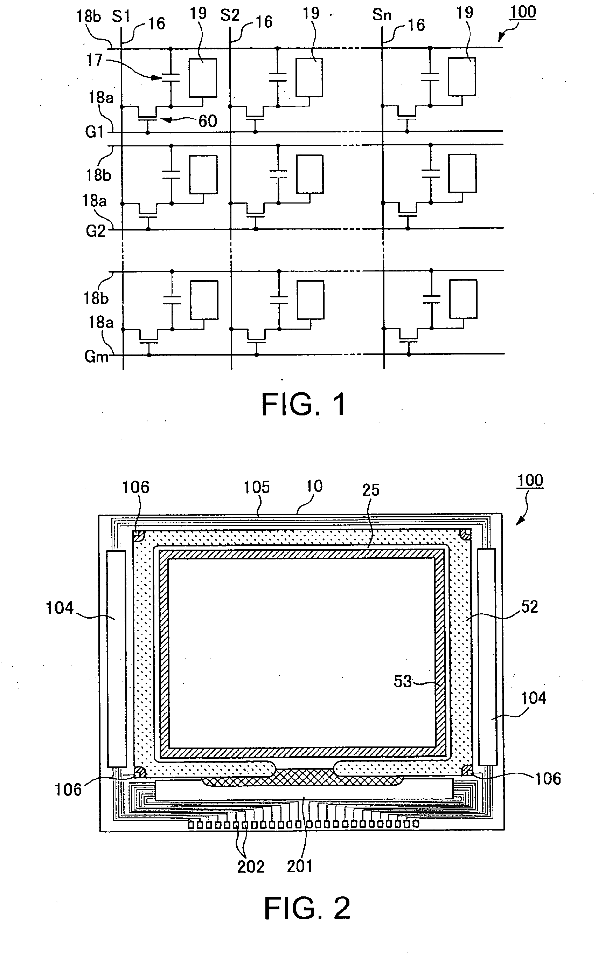

Fig. 1 is an equivalent circuit diagram illustrating a liquid crystal display 100 that is an electro-optical device according to one embodiment of the invention. The liquid crystal display 100 of the present embodiment includes a plurality of dots arranged in a matrix. Formed in each dot are a pixel electrode 19 and a TFT 60 that is a switching element for controlling the pixel electrode 19. A data line (electrode wire) 16 to which an image signal is supplied is electrically coupled to the source of the corresponding TFT 60. Image signals S1, S2, ..., and Sn to be written to the data lines 16 are sequentially supplied in that order, or plural image signals of a respective one of signal groups are in turn supplied to the corresponding plural data lines 16 adjacent to each other. Furthermore, scan lines (electrode wires) 18a are electrically coupled to the gates of the TFTs 60, and scan signals G1, G2, ..., and Gm are pulsatively and line-sequentially applied to the plural scan lines 18a at predetermined timing. In addition, the pixel electrodes 19 are electrically coupled to the drains of the TFTs 60. By turning on the TFTs 60, which are a switching element, only for a predetermined period, the image signals S1, S2, ..., and Sn supplied from the data lines 16 are written to the pixel electrodes 19 at predetermined timing.

The image signals S1, S2, ..., and Sn of a certain level written via the pixel electrodes 19 to the liquid crystal are held between a common electrode to be described later and the pixel electrodes 19 for a predetermined period. The orientation and order of molecular aggregates in the liquid crystal change according to the level of the applied voltage. These changes permit modulation of light, which allows displaying of any gray-scale. In each dot, in order to prevent leakage of the image signals written to the liquid crystal, a storage capacitor 17 is added in parallel to a liquid crystal capacitor formed between the pixel electrode 19 and the common electrode. The liquid crystal display 100 also includes capacitance lines 18b that are each coupled to one electrode of the storage capacitor 17.

Fig. 2 is a diagram illustrating the entire structure of the liquid crystal display 100. In the liquid crystal display 100, a TFT array substrate 10 and a counter substrate 25 are applied to each other with a sealing material 52 therebetween having a substantially rectangular frame shape in plan view. The liquid crystal is sandwiched between the both substrates 10 and 25, and is enclosed between the substrates by the sealing material 52. Note that Fig. 2 illustrates the display so that the outer circumference of the counter substrate 25 corresponds with that of the sealing material 52 in plan view.

In an inside region of the sealing material 52, a light-shielding film (peripheral partition) 53 composed of a light-shielding material is formed in a rectangular frame shape. On the peripheral circuit region outside the sealing material 52, a data line drive circuit 201 and mounting terminals 202 are provided along one side of the TFT array substrate 10, and scan line drive circuits 104 are provided along two sides adjacent to the one side. On the rest one side of the TFT array substrate 10, a plurality of wires 105 for coupling the scan line drive circuits 104 to each other are formed. In addition, on corners of the counter substrate 25, a plurality of inter-substrate conductive materials 106 are provided to electrically couple the TFT array substrate 10 to the counter substrate 25.

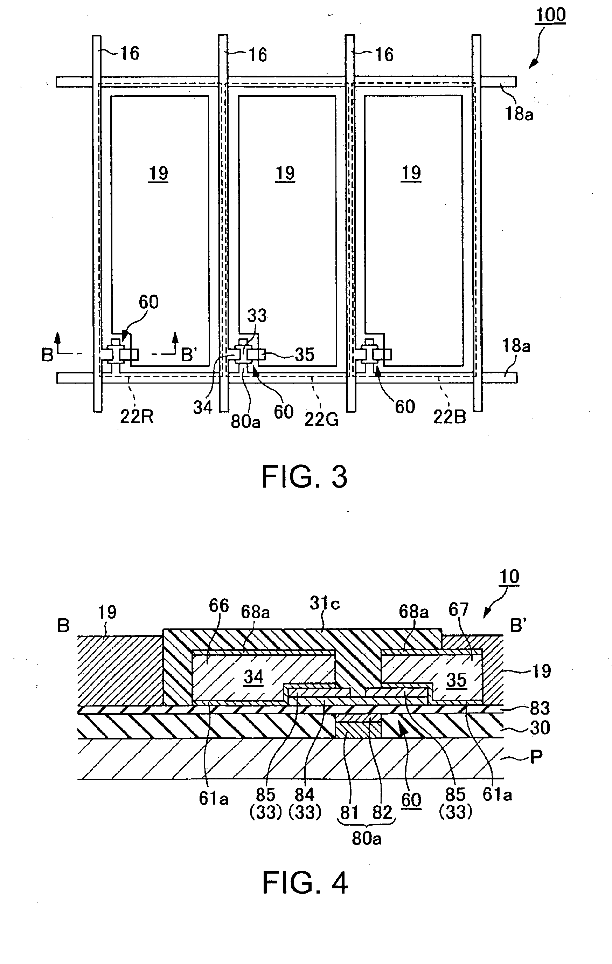

Fig. 3 is a plan view illustrating the pixel structure of the liquid crystal display 100. Referring to Fig. 3, in the display region of the liquid crystal display 100, the plural scan lines 18a extend laterally in the drawing while the plural data lines 16 extend in the direction perpendicular to the scan lines. In Fig. 3, regions each surrounded by the scan line 18a and the data line 16 and having a rectangular shape in plan view are dot regions. A color filter of one color of the three primary colors is formed corresponding to one dot region. Three dot regions in the drawing constitute one pixel region having colored parts 22R, 22G and 22B of three colors. The colored parts 22R, 22G and 22B are periodically arranged in the display region of the liquid crystal display 100.

Each dot region shown in Fig. 3 includes the pixel electrode 19 composed of an optical transparent conductive film such as an indium tin oxide (ITO) film and having a substantially rectangular shape in plan view. The TFT 60 is intervened between the pixel electrode 19 and the scan line 18a, and between the pixel electrode 19 and the data line 16. The TFT 60 includes a semiconductor layer 33, a gate electrode 80a provided under the semiconductor layer 33 (closer to the substrate than the semiconductor layer 33), a source electrode 34 and a drain electrode 35 that are provided over the semiconductor layer 33. The channel region of the TFT 60 is formed in a region, in the semiconductor layer 33, facing the gate electrode 80a. Source and drain regions are formed in the semiconductor layers on the both sides of the channel region.

The gate electrodes 80a are formed of branches from the scan lines 18a along the extension direction of the data lines 16. The tip of the branch faces the semiconductor layer 33 along the direction perpendicular to the drawing plane with an insulating film (gate insulating film, not shown) therebetween. The source electrodes 34 are formed of branches from the data lines 16 along the extension direction of the scan lines 18a, and are electrically coupled to the semiconductor layers 33 (source regions). One end (left end in the drawing) of the drain electrode 35 is electrically coupled to the semiconductor layer 33 (drain region), while the other end (right end in the drawing) of the drain electrode 35 is electrically coupled to the pixel electrode 19.

With such a structure, the TFT 60 is turned on by a gate signal input via the scan line 18a for a certain period. Thus, the TFT 60 functions as a switching element that writes an image signal supplied via the data line 16 to the liquid crystal at predetermined timing.

Fig. 4 is a diagram illustrating the sectional structure of the TFT array substrate 10 along the line B-B' of Fig. 3. Referring to the sectional structure in the drawing, the TFT array substrate 10 mainly includes the TFT 60 formed on the inner surface (upper surface in the drawing) of a glass substrate P, and the pixel electrode 19. A bank 30 having an opening in part thereof is formed on the glass substrate P. The gate electrode 80a is buried in the opening of the bank 30. The gate electrode 80a has a structure in which a first electrode layer (base layer) 81 composed of a metal material such as Ag, Cu or Al and a second electrode layer (cover layer, outer surface layer) 82 composed of a metal material such as Ni, Ti, W or Mn are deposited on the glass substrate P.

A gate insulating film 83 composed of silicon oxide, silicon nitride or the like is formed on the bank 30 and the gate electrode 80a. The semiconductor layer 33 is formed at a position located on the gate insulating film 83 and horizontally overlapping with the gate electrode 80a. The semiconductor layer 33 is made up of an amorphous silicon layer 84 and an N⁺ silicon layer 85 deposited on the amorphous silicon layer 84. The N⁺ silicon layer 85 is divided into two parts horizontally separated from each other on the amorphous silicon layer 84. One N⁺ silicon layer 85 (left side in the drawing) is electrically coupled to the source electrode 34 formed on the gate insulating film 83 and the one N⁺ silicon layer 85. The other N⁺ silicon layer 85 is electrically coupled to the drain electrode 35 formed on the gate insulating film 83 and the other N⁺ silicon layer 85.

The source electrode 34 is an electrode member of a three-layer structure formed by depositing a barrier metal film (barrier layer, outer surface layer) 61a, a source electrode film (base layer) 66 and a cover metal film (cover layer, outer surface layer) 68a on top of each other. The drain electrode 35 is also an electrode member of a three-layer structure formed by depositing the barrier metal film (barrier layer, outer surface layer) 61 a, a drain electrode film (base layer) 67 and the cover metal film (cover layer, outer surface layer) 68a on top of each other. The barrier metal film 61a is formed of at least one metal material selected from nickel (Ni), titanium (Ti), tungsten (W), manganese (Mn) and the like. The source and drain electrode films 66 and 67 are formed of at least one metal material selected from silver (Ag), copper (Cu), aluminum (Al) and the like. The cover metal film 68a is formed of at least one metal material selected from Ni, Ti, W, Mn and the like as with the barrier metal film 61a.

The data lines 16 and the scan lines 18a are formed integrally with the source electrodes 34 and the gate electrodes 80a, respectively, as shown in Fig. 3. Therefore, the date lines 16 are an electrode member having the same three-layer structure as that of the source electrodes 34, and the scan lines 18a are an electrode member having the same two-layer structure as that of the gate electrodes 80a.

A bank 31c is formed to cover part of the surface of the drain electrode 3 5 and the source electrode 34. The bank 31c is formed, on the glass substrate P, in a substantially grid shape in plan view having openings corresponding to the pixel electrodes 19 shown in Fig. 3. In manufacturing of the liquid crystal display 100, the bank 31c is formed as a partition member for pattern-forming the pixel electrodes 19 with using a liquid phase method. As shown in Fig. 4, the pixel electrode 19 is formed to come into contact with the upper and side surfaces of the drain electrode 35 protruding from the insulating film 31c toward the right side in the drawing, and is electrically coupled to the drain electrode 35.

An alignment film for controlling the initial orientation state of the liquid crystal is formed on the surfaces of the pixel electrodes 19 and the insulating film 31 c. In addition, a phase plate and a polarizing plate for controlling the polarization state of light incident on the liquid crystal layer are provided on the outer surface of the glass substrate P. Furthermore, a backlight used as an illumination unit in transparent or semitransparent reflective liquid crystal displays is provided outside the TFT array substrate 10 (on the back side of the panel).

Deposited on the inner surface (the surface facing the TFT array substrate 10) of the counter substrate 25 are a color filter layer including the arranged colored parts 22R, 22G and 22B shown in Fig. 3 and a counter electrode composed of an optical transparent conductive film formed in a planar blanket form, although detailed illustration is omitted. In addition, an alignment film similar to that on the TFT array substrate 10 is formed on the counter electrode. A phase plate and a polarizing plate are provided on the outer surface of the counter substrate if needed.

The liquid crystal layer enclosed between the TFT array substrate 10 and the counter substrate 25 is composed mainly of liquid crystal molecules. Any liquid crystal molecule, such as a nematic liquid crystal or smectic liquid crystal molecule, may be used as the liquid crystal molecule constituting the liquid crystal layer as long as it can be oriented. For a TN liquid crystal panel, a liquid crystal molecule forming a nematic liquid crystal is preferable. Examples of the material for a nematic liquid crystal include a phenylcyclohexane derivative liquid crystal, biphenyl derivative liquid crystal, biphenylcyclohexane derivative liquid crystal, terphenyl derivative liquid crystal, phenyl ether derivative liquid crystal, phenyl ester derivative liquid crystal, bicyclohexane derivative liquid crystal, azomethine derivative liquid crystal, azoxy derivative liquid crystal, pyrimidine derivative liquid crystal, dioxane derivative liquid crystal, and cubane derivative liquid crystal.

In the liquid crystal display 100 of the present embodiment having the above-described structure, the orientation state of the liquid crystal layer is controlled by voltage application, and light incident from the backlight is modulated by the liquid crystal layer. This modulation enables displaying of any gray-scale. Since the colored parts 22R, 22G and 22B are provided for the dots, color light rays of the three primary colors (R, G, B) are mixed in each pixel to thereby allow displaying of any color.

In the liquid crystal display 100 of the present embodiment, the gate electrodes 80a, the source electrodes 34 and the drain electrodes 35 of the TFTs 60 and the pixel electrodes 19 are pattern-formed by using a liquid phase method. The source electrode 34 has a structure in which the cover metal film 68a, which is the cover layer (outer surface layer), is deposited on the source electrode film 66, which is the base layer. The drain electrode 35 has a structure in which the cover metal film 68a, which is the cover layer (outer surface layer), is deposited on the drain electrode film 67, which is the base layer. Thus, the cover metal films 68a can effectively prevent the metal material, such as Ag, Cu or Al, of the electrode films 66 and 67 from diffusing into the insulating film 31c. Note that the cover metal films 68a may be omitted if the diffusion leads to no problem.

In addition, The source and drain electrodes 34 and 35 are formed by depositing the source and drain electrode films 66 and 67, respectively, which are the base layer, on the barrier metal film 61a. Thus, the barrier metal film 61a can favorably prevent the metal material, such as Ag, Cu or Al, of the electrode films 66 and 67 as the base layer from diffusing into the N⁺ silicon layers 85 and the amorphous silicon layer 84. Therefore, operational defects and performance degradation of the TFTs 60 due to the diffusion can be prevented.

In addition, electrode members formed by using a liquid phase method are used for the TFTs 60 and the pixel electrodes 19 constituting the dots in the liquid crystal display 100. Therefore, the number of processes employing expensive vacuum equipment can be reduced, and the efficiency of material use can be enhanced. Thus, manufacturing costs of liquid crystal displays can be lowered.

Furthermore, since the gate electrode 80a has a two-layer structure of the first and second electrode layers 81 and 82, the second electrode layer 82 as the cover layer (outer surface layer) can effectively prevent the metal material, such as Ag, Cu or Al, of the first electrode layer 81 as the base layer from diffusing into the gate insulating film 83. Thus, operational defects, lowering of the mobility and so on of the TFTs 60 due to the diffusion can be prevented.

In the liquid crystal display 100 of the present embodiment, the mounting terminals 202 may have the same structure and may be formed on the same layer-level as those of the source electrodes 34 (data lines 16) or the gate electrodes 80a (scan lines 18a). Specifically, in the forming step of the source electrodes 34 or the gate electrodes 80a, the mounting terminals 202 may be formed simultaneously with forming of the source electrodes 34 or the gate electrodes 80a. With such a structure, the mounting terminals 202 have the cover layer composed of Ni, Ti, W or the like on the surface thereof. When the mounting layers 202 are solder-bonded to external circuits, the cover layer provides good bonding. This is because the structure in which the cover layer composed of Ni or the like is formed allows adhesion of the solder with better wettability compared with the structure in which the metal material, such as Ag, Cu or Al, of the base layer is exposed in the surfaces of the mounting terminals 202.

Although the gate electrode 80a has a two-layer structure formed of the first and second electrode layers 81 and 82 in the present embodiment, an adhesion layer may be formed between the first electrode layer 81 and the glass substrate P to enhance the adhesion therebetween. The adhesion layer can be formed of Mn, for example, and can be formed by a liquid phase method employing a liquid material including Mn fine particles dispersed therein.

### Method of Manufacturing Thin Film Transistor

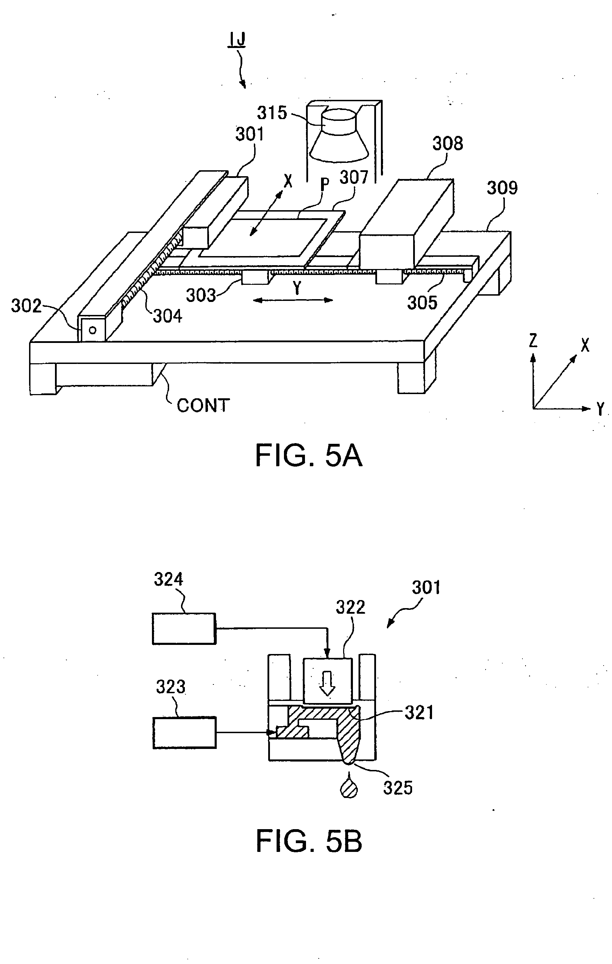

An embodiment of manufacturing method of a TFT array substrate including a method of manufacturing a thin film transistor according to an embodiment of the invention will be described with reference to Figs. 5A to 11. It should be noted that in each drawing, the scale of each layer and each part is varied to illustrate each layer and each part with such a size to be recognizable on the drawing.

### Droplet Discharge Device

Initially, a droplet discharge device used in plural steps of the present manufacturing method will be described below. In the present manufacturing method, ink (liquid material) including conductive fine particles is discharged as droplets from nozzles of a droplet discharge head included in a droplet discharge device, to thereby form each electrode member and each electrode constituting a thin film transistor. As the droplet discharge device used in the present embodiment, a device having a structure shown in Fig. 5A can be used.

Fig. 5A is a perspective view illustrating the schematic structure of a droplet discharge device IJ used in the present embodiment.

The droplet discharge device IJ includes a droplet discharge head 301, an X-axis direction drive shaft 304, a Y-axis direction guide shaft 305, a control device CONT, a stage 307, a cleaning mechanism 308, a base 309, and a heater 315.

The stage 307 supports a substrate P to which ink (liquid material) is provided by the droplet discharge device IJ, and includes a fixing mechanism (not shown) for fixing the substrate P to a reference position.

The droplet discharge head 301 is a multi-nozzle type droplet discharge head including a plurality of discharge nozzles. The longitudinal direction of the head 301 coincides with the X-axis direction. The plurality of nozzles is provided on the lower surface of the droplet discharge head 301 with being arranged along the X-axis direction at a constant interval. Ink containing conductive fine particles is discharged from the discharge nozzles of the droplet discharge head 301 to the substrate P supported by the stage 307.

An X-axis direction drive motor 302 is connected to the X-axis direction drive shaft 304. The X-axis direction drive motor 302 is a stepping motor or the like and rotates the X-axis direction drive shaft 304 when a driving signal for the X-axis direction is supplied from the control device CONT. The rotation of the X-axis direction drive shaft 304 causes the movement of the droplet discharge head 301 in the X-axis direction.

The Y-axis direction guide shaft 305 is fixed to the base 309 so as not to move. The stage 307 is equipped with a Y-axis direction drive motor 303. The Y-axis direction drive motor 303 is a stepping motor or the like, and moves the stage 307 in the Y-axis direction when a driving signal for the Y-axis direction is supplied from the control device CONT.

The control device CONT supplies to the droplet discharge head 301 voltages for controlling droplet discharge. Furthermore, the control device CONT also supplies to the X-axis direction drive motor 302 a drive pulse signal for controlling the movement of the droplet discharge head 301 in the X-axis direction, and to the Y-axis direction drive motor 303 a drive pulse signal for controlling the movement of the stage 307 in the Y-axis direction.

The cleaning mechanism 308 cleans the droplet discharge head 301. The cleaning mechanism 308 is equipped with a drive motor (not shown) for the Y-axis direction. By driving the Y-axis direction drive motor, the cleaning mechanism is moved along the Y-axis direction guide shaft 305. The movement of the cleaning mechanism 308 is also controlled by the control device CONT.

The heater 315 is a unit to subject the substrate P to heat treatment by lump annealing, and evaporates and dries the solvent contained in a liquid material applied on the substrate P. Turning on and off of power supply to the heater 315 are also controlled by the control device CONT.

The droplet discharge device IJ discharges droplets to the substrate P while the droplet discharge head 301 and the stage 307 supporting the substrate P are scanned relative to each other. Here, in the following explanations, the Y-axis direction is defined as a scan direction, while the X-axis direction perpendicular to the Y-axis direction is defined as a non-scan direction. Therefore, the discharge nozzles of the droplet discharge head 301 are arranged along the X-axis direction, which is the non-scan direction, at a constant interval. Although in Fig. 5A, the droplet discharge head 301 is disposed so that the longitudinal direction thereof intersects at a right angle with the moving direction of the substrate P, the angle of the droplet discharge head 301 may be adjusted so that the longitudinal direction thereof intersects at an oblique angle with the moving direction of the substrate P. Accordingly, a pitch between the nozzles can be adjusted by adjusting the angle of the droplet discharge head 301. In addition, a function of adjusting the distance between the substrate P and the nozzle surface to any value may be provided.

Fig. 5B is a diagram illustrating the schematic structure of a droplet discharge head and explaining a principle of discharging a liquid material by a piezo method.

Referring to Fig. 5B, a piezo element 322 is disposed adjacent to a liquid chamber 321 storing a liquid material (ink, functional liquid). The liquid material is supplied to the liquid chamber 321 through a liquid material supply system 323 including a material tank for storing the liquid material. The piezo element 322 is connected to a driving circuit 324. A voltage is applied to the piezo element 322 via the driving circuit 324 to deform the piezo element 322, so that the liquid chamber 321 is elastically deformed. The changes of the inside volume of the liquid chamber 321 when elastically deformed cause the liquid material to be discharged from a nozzle 325. In this case, the strain amount of the piezo element 322 can be controlled by changing the value of the applied voltage. In addition, the strain velocity of the piezo element 322 can be controlled by changing the frequency of the applied voltage. Droplet discharging by the piezo method applies no heat to the material and thus has an advantage of having less influence on the composition of the material.

### Ink (Liquid Material)

Ink (liquid material) used in the manufacturing method according to the present embodiment and preferable for being discharged from the droplet discharge head 301 will be described.

The ink (liquid material) for forming electrode members used in the present embodiment is composed of a dispersion liquid including conductive fine particles dispersed in a dispersion medium, or a precursor thereof. As the conductive fine particles, metal fine particles including any of gold, silver, copper, palladium, niobium, nickel and the like are used for example. Alternatively, fine particles of a precursor, alloy or oxide of these metals, fine particles of a conductive polymer or an indium tin oxide, or other fine particles are used. These conductive fine particles may be used while the surface thereof is coated with an organic substance in order to enhance the dispersibility. It is preferable that the particle diameter of the conductive fine particles be in a range of about 1 nm to 0.1 µm. If the diameter is larger than 0.1 µm, there are possibilities of clogging in the nozzles of the liquid discharge head 301 to be described later, and insufficient density of the obtained film. In addition, if the diameter is smaller than 1 nm, the volume ratio of a coating agent to the conductive fine particles is large, resulting in an excess percentage of the organic substance in the obtained film.

There is no particular limitation on the dispersion medium as long as it can disperse the above-described conductive fine particles and does not cause aggregation. For example, besides water, the following materials can be exemplified: alcohols such as methanol, ethanol, propanol, and butanol; hydro-carbon compounds such as n-heptane, n-octane, decane, dodecane, tetradecane, toluene, xylene, cymene, durene, indene, dipentene, tetrahydronaphthalene, decahydronaphthalene, and cyclohexylbenzene; ether compounds such as ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, 1,2-dimethoxyethane, bis (2-methoxyethyl) ether, and p-dioxane; polar compounds such as propylene carbonate, gamma-butyrolactone, N-methyl-2-pyrrolidone, dimethylformamide, dimethyl sulfoxide, and cyclohexanone; and so on. Of these materials, water, alcohols, carbon hydride compounds, and ether compounds are preferable in terms of dispersibility of fine particles, stability of a dispersion liquid and ease of application to a droplet discharge method (ink jet method). As a more preferable dispersion medium, water and carbon hydride compounds can be cited.

It is preferable that the surface tension of the dispersion liquid for the conductive fine particles be in the range of 0.02 N/m to 0.07 N/m. In discharging liquid by an ink jet method, if the surface tension is below 0.02 N/m, the wettability of the ink composition to the nozzle surface is large and thus flight deflection is easily caused. If the surface tension exceeds 0.07 N/m, the meniscus shape at the tip of the nozzle is unstable, which makes it difficult to control discharge amount and discharge timing. In order to adjust the surface tension, a small amount of a surface tension regulating agent, such as a fluorine-based, silicone-based, or nonionic-based agent, may be added to the above-described dispersion liquid to such an extent that the contact angle of the liquid to the substrate is not significantly lowered. The nonionic-based surface tension regulating agent serves to enhance the wettability of a liquid to a substrate, and improve the leveling property of a film to prevent generation of minute recesses and projections of the film. The surface tension regulating agent may include, if needed, an organic compound, such as alcohol, ether, ester, or ketone.

It is preferable that the viscosity of the above-described dispersion liquid be in the range of 1 mPa·s to 50 mPa·s. In discharging a liquid material as droplets by an ink jet method, if the viscosity is below 1 mPa·s, the peripheral areas of the nozzles are easily contaminated due to flow out of the ink. If the viscosity is greater than 50 mPa·s, the frequency of clogging in nozzle openings is increased, which makes it difficult to discharge droplets smoothly and reduce the droplet discharge amount.

### Method of Manufacturing TFT Array Substrate

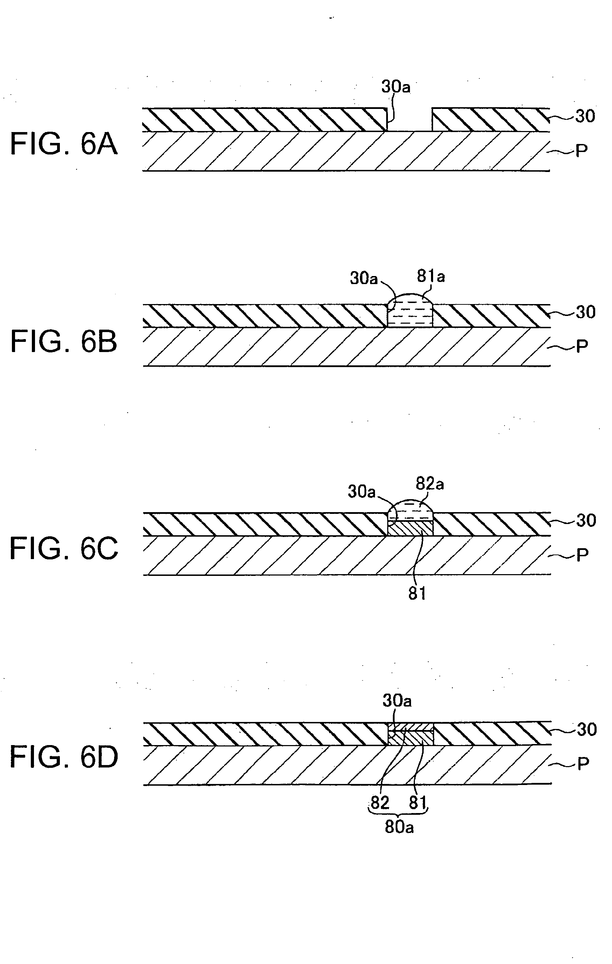

Each manufacturing step of a TFT array substrate will be described below referring to Figs. 6A to 10C. Figs. 6A to 10C are sectional views illustrating a series of steps in the manufacturing method of the present embodiment.

The manufacturing method of the present embodiment is a method of manufacturing a TFT array substrate through the following procedure. Specifically, banks are formed on a glass substrate, and electrode and wire patterns are formed in regions surrounded by the banks by a droplet discharge method employing a droplet discharge device, to thereby fabricate thin film transistors.

### Gate Electrode Forming Step

Initially, as shown in Figs. 6A to 6D, the glass substrate P serving as a base is prepared and the bank 30 is formed on one surface of the glass substrate P. Subsequently, predetermined ink is dropped in an opening 30a provided in the bank 30 to thereby form the gate electrode 80a in the opening 30a. The gate electrode forming step includes a bank forming step, a lyophobicity providing treatment step, a first electrode layer forming step, a second electrode layer forming step, and a baking step.

### Bank Forming Step

Initially, in order to form the gate electrode 80a (and the scan line 18a) having a certain pattern on a glass substrate, the bank 30 having the opening 30a of a certain pattern is formed on the glass substrate P as shown in Fig. 6A. The bank 30 is a partition member for horizontally separating the substrate surface. Any method, such as photolithography or printing, can be used for forming the bank. When using photolithography for example, an organic photosensitive material such as acrylic resin is applied to a height corresponding to the height of the bank to be formed on the glass substrate P by a certain method such as spin coating, spray coating, roll coating, die coating or dip coating, to thereby form a photosensitive material layer. Subsequently, the photosensitive material layer is irradiated with ultraviolet rays according to the shape of the bank to be formed to thereby form the bank 30 having the opening 30a for the gate electrode. The bank 30 may be an inorganic structure formed by using a liquid material including polysilazane or the like.

### Lyophobicity Providing Treatment Step

Subsequently, lyophobicity providing treatment is implemented for the bank 30 to provide the surface thereof with lyophobicity. As the lyophobicity providing treatment, plasma treatment (CF₄ plasma treatment) employing tetrafluoromethane as the treatment gas in an air atmosphere can be adopted for example. Conditions for this CF₄ plasma treatment are as follows, for example: a plasma power of 50 kW-1000 kW, a tetrafluoromethane gas flow rate of 50 ml/min-100 ml/min, a substrate conveying rate of 0.5 mm/sec-1020 mm/sec relative to a plasma discharge electrode, and a substrate temperature of 70° C-90° C. Note that the treatment gas is not limited to tetrafluoromethane (tetrafluorocarbon), but another fluorocarbon gas can also be used.

Such lyophobicity providing treatment introduces a fluorine group in resin constituting the bank 30 and thus provides the bank 30 with high lyophobicity.

Furthermore, it is preferable to carry out ashing treatment employing O₂ plasma or ultraviolet rays (UV) irradiation treatment prior to the lyophobicity providing treatment in order to clean the surface of the glass substrate P exposed in the bottom surface of the opening 30a. This treatment can remove residues of the bank from the surface of the glass substrate P, which can increase the difference between the contact angle of liquid on the lyophobicity-provided bank 30 and that on the glass substrate surface. Thus, droplets to be provided in the opening 30a in the subsequent step can accurately be confined inside the opening 30a. When the bank 30 is composed of acrylic resin or polyimide resin, the bank 30 is fluorinated (provided with lyophobicity) more easily if the bank 30 is exposed to O₂ plasma prior to CF₄ plasma treatment. Therefore, it is preferable to implement O₂ ashing treatment prior to CF₄ plasma treatment if the bank 30 is composed of these resin materials.

Specifically, the O₂ ashing treatment is performed by irradiating the substrate P with plasma oxygen from a plasma discharge electrode. Conditions for the O₂ ashing treatment are as follows, for example: a plasma power of 50 W-1000 W, an oxygen gas flow rate of 50 ml/min-100 ml/min, a conveying rate of the substrate P of 0.51 mm/sec-10 mm/sec relative to the plasma discharge electrode, and a substrate temperature of 70° C-90° C.

The lyophobicity providing treatment (CF₄ plasma treatment) for the bank 30 has some influences on the surface of the substrate P provided with lyophilicity through the preceding residue treatment. However, if the substrate P is a glass substrate or the like in particular, introduction of a fluorine group into the substrate P by the lyophobicity providing treatment hardly occurs, and thus the lyophilicity, i.e., the wettability of the substrate P is not deteriorated substantially. By forming the bank 30 from a material having lyophobicity (a resin material having a fluorine group, for example), the lyophobicity providing treatment therefor may be omitted.

### First Electrode Layer Forming Step

Subsequently, as shown in Fig. 6B, ink 81a for forming a first electrode layer is dropped to the opening 30a from the droplet discharge head 301 of the droplet discharge device IJ. Here, the ink 81a to be discharged and disposed includes silver (Ag) fine particles as conductive fine particles and diethylene glycol diethyl ether as a solvent (dispersion medium). The surface of the bank 30 is provided with lyophobicity, while the substrate surface in the bottom of the opening 30a is provided with lyophilicity. Therefore, even when part of the discharged droplets lands on the bank 30, the droplets are repelled from the bank surface so as to be displaced into the opening 30a.

After the discharging of droplets of the ink for forming an electrode, drying treatment is carried out if needed in order to remove the dispersion medium. The drying treatment can be implemented by heating treatment employing a typical hot plate or electric furnace for heating the substrate P, for example. In the present embodiment, heating at about 180° C for about 60 minutes is carried out for example. The heating is not necessarily carried out in an air atmosphere but may be carried out in a nitrogen gas atmosphere for example.

The drying treatment may be implemented by lamp annealing. Examples of light sources for the lamp annealing include, but not limited to, an infrared lamp, xenon lamp, YAG laser, argon laser, carbon dioxide laser, and excimer laser of XeF, XeCl, XeBr, KrF, KrCl, ArF, ArCl, or the like. Typically a light source having output power in the range of 10W to 5000W is used. In the present embodiment, output power in the range of 100W to 1000W is sufficient. This intermediate drying step forms the solid first electrode layer 81 as shown in Fig. 6C.

### Second Electrode Layer Forming Step

Subsequently, as shown in Fig. 6C, ink 82a for forming a second electrode layer is deposited in the opening 30a of the bank 30 by using a droplet discharge method employing a droplet discharge device. Here, the ink (liquid material) to be discharged and disposed includes nickel (Ni) fine particles as conductive fine particles and water and diethanolamine as a solvent (dispersion medium). The surface of the bank 30 is provided with lyophobicity, while the substrate surface in the bottom of the opening 30a is provided with lyophilicity. Therefore, even when part of the discharged droplets lands on the bank 30, the droplets are repelled from the bank surface so as to be displaced into the opening 30a. However, the surface of the first electrode layer 81 that has been formed inside the opening 30a in advance does not always have a high affinity for the ink 82a dropped in the present step. Therefore, an intermediate layer may be formed to improve the wettability of the ink 82a on the first electrode layer 81 prior to the dropping of the ink 82a. The kind of the intermediate layer is appropriately selected according to the kind of the dispersion medium constituting the ink 82a. When the ink 82a includes a water-based dispersion medium like the present embodiment, provision of the intermediate layer composed of titanium oxide, for example, offers extremely favorable wettability on the surface of the intermediate layer.

After the discharging of the droplets, drying treatment is carried out if needed in order to remove the dispersion medium. The drying treatment can be implemented by heating treatment employing a typical hot plate or electric furnace for heating the substrate P, for example. The treatment conditions are as follows for example: a heating temperature of about 180° C, and a heating time period of about 60 minutes. The heating is also not necessarily carried out in an air atmosphere but may be carried out in a nitrogen gas atmosphere for example.

The drying treatment may be implemented by lamp annealing. Examples of light sources used in the lamp annealing may be the same as those for the intermediate drying step after the preceding first electrode layer forming step. The output power of the light sources when heating may also be in the range of 100 W to 1000 W similarly. This intermediate drying step forms the solid second electrode layer 82 on the first electrode layer 81 as shown in Fig. 6D.

### Baking Step

The dispersion medium needs to be completely removed from the dried film obtained after the discharging step, in order to enhance electric contact among the fine particles. In addition, if the surfaces of the conductive fine particles are coated with a coating agent, such as an organic substance, to enhance the dispersibility of the particles in the liquid, this coating agent also needs to be removed. Therefore, heat treatment and/or light treatment are implemented for the substrate after the discharging step.

The heat treatment and/or light treatment are typically carried out in an air atmosphere. If necessary, the treatment may also be carried out in an inactive gas atmosphere, such as a nitrogen, argon, or helium atmosphere. The treatment temperature for the heat treatment and/or light treatment is appropriately determined with taking into consideration the boiling point (vapor pressure) of the dispersion medium, the kind and pressure of the atmospheric gas, the dispersibility, oxidizability and other thermal behaviors of the fine particles, the presence and volume of the coating agent, the heat resistance temperature of the base material, and so on. Since the first and second electrode layers are formed by using the above-described materials, a baking temperature equal to or lower than 250° C is available. In the present step, the baking temperature can be enhanced under the allowable temperature limit of the bank 30 since a semiconductor layer has not been provided on the substrate P. A baking temperature above 250° C or of about 300° C for example allows formation of metal wires having more favorable conductivity.

Through the above steps, electric contact among the fine particles in the dried film obtained after the discharging step is ensured and thus the dried film is converted into a conductive film. Therefore, the gate electrode 80a formed of a multi-layer structure of the first and second electrode layers 81 and 82 is formed in the opening 30a of the bank 30. In addition, the scan lines 18a integrated with the gate electrodes 80a are also formed on the glass substrate P through the above steps as shown in Fig. 3.

It is preferable that the thickness of the first electrode layer 81 be in the range of about 500 mn to 1500 nm and the thickness of the second electrode layer 82 be in the range of about 20 nm to 400 nm after the baking step. A thickness under 20 nm of the second electrode layer 82 cannot sufficiently prevent diffusion of the metal atoms from the first electrode layer 81 into the gate insulating film 83. In addition, a thickness over 400 nm increases the resistance of the gate electrode 80a (and the scan line 18a).

In the above-described steps, the first electrode layer 81 composed of Ag and the second electrode layer 82 composed of Ni are formed to thereby form the gate electrode 80a made up of a multi-layer structure of the first and second electrode layers 81 and 82. However, the first electrode layer 81 may be made of a metal other than Ag, such as Cu or Al, or an alloy based on these metals, for example. In addition, the second electrode layer 82 may be composed of a metal other than Ni, such as Ti, W or Mn, or an alloy based on these metals.

### Gate Insulating Film Forming Step

Subsequently, a gate insulating film 83 composed of silicon nitride is formed on the gate electrode 80a and the bank 30. The gate insulating film 83 can be formed by depositing a film over the entire surface by plasma CVD for example, and then appropriately patterning the film by photolithography. As the raw material gas used in the CVD step, any of a mixture gas of monosilane and dinitrogen monoxide, TEOS (tetratetraethoxysilane Si(OC₂H₅)₄), oxygen, disilane, ammonium and so forth are preferable. The thickness of the formed gate insulating film 83 is about 150 nm-400 nm.

### Semiconductor Layer Forming Step

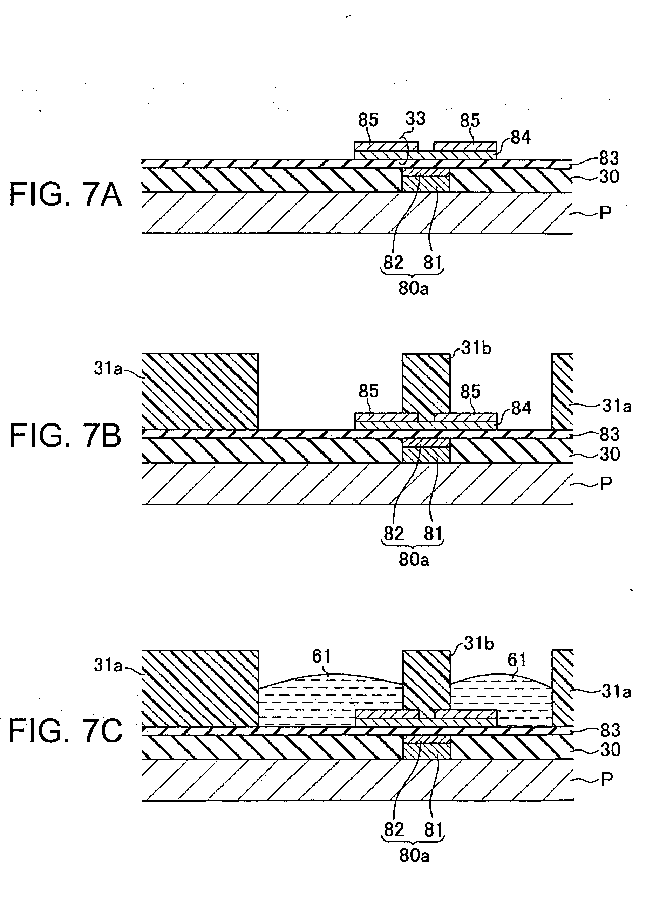

Subsequently, the semiconductor layer 33 shown in Fig. 7A is formed on the gate insulating film 83. In order to obtain the semiconductor layer 33, an amorphous silicon film having a thickness of about 150 nm-250 nm and an N⁺ silicon film having a thickness of about 50 nm-100 nm are deposited by plasma CVD or the like over the entire surface of the substrate P on which the gate insulating film 83 has been formed. Subsequently, the films are patterned into a certain shape by photolithography. Disilane and monosilane are preferable as the raw material gas used in the forming step of the amorphous silicon film. In the subsequent forming step of the N⁺ silicon film, the film can be deposited by introducing a raw material gas for forming the N⁺ silicon film into the deposition apparatus used for forming the amorphous silicon film.

Subsequently, the amorphous silicon film and the N⁺ silicon film are patterned into a shape shown in Fig. 7A by photolithography, to thereby obtain on the insulating film 83 the semiconductor layer 33 made up of a multi-layer structure of the amorphous silicon layer 84 and the N⁺ silicon film 85 that have certain planar shapes. In the patterning, a resist pattern having a planar shape corresponding to the planar shape of the semiconductor layer 33 is selectively disposed on the surface of the N⁺ silicon film, and then etching is carried out with using the resist pattern as a mask. Through such patterning, the N⁺ silicon film 85 is selectively removed and thus the N⁺ silicon film 85 is divided into two regions on a region horizontally overlapping with the gate electrode 80a. These two N⁺ silicon layers 85 form a source contact region and a drain contact region.

### Electrode Forming Step

Subsequently, the source and drain electrodes 34 and 35 shown in Fig. 4 are formed on the glass substrate P on which the semiconductor layer 33 has been formed. The electrode forming step includes a bank forming step, a lyophobicity providing step, a barrier metal film forming step, an electrode film forming step, a cover metal film forming step, and a baking step.

### Bank Forming Step

After the amorphous silicon layer 84 and the N⁺ silicon layer 85 are formed, a bank for forming the source and drain electrodes are formed on the glass substrate P. The bank can be formed with any method, such as photolithography or printing. When using photolithography for example, an organic photosensitive material based on acrylic resin is applied to a height corresponding to the height of the bank to be formed by a certain method such as spin coating, spray coating, roll coating, die coating or dip coating, to thereby form a photosensitive material layer. Thereafter, the photosensitive material layer is irradiated with ultraviolet rays according to the shape of the bank to be formed.

Here, two kinds of the banks, i.e., a first bank 31b and a second bank 31a are formed. Initially exposure by irradiation with ultraviolet rays is implemented for the first bank 31b so that the first bank 31b is located over the amorphous silicon layer 84 and the N⁺ silicon layer 85, and over the almost center part of the amorphous silicon layer 84 as shown in Fig. 7B. Specifically, the first bank 31b is formed as a partition member for horizontally separating the source electrode from the drain electrode to be formed in the subsequent step. In contrast, the second bank 31a is formed on a region outside the amorphous silicon layer 84 in a manner of surrounding the amorphous silicon layer 84 as shown in Fig. 7B.

The banks 31a and 31b may be an inorganic structure formed by using a liquid material including polysilazane or the like. In the case of forming banks composed of an inorganic material, a heating temperature for curing the banks is often higher compared with the case of forming banks by using an organic material such as a resin material. However, a curing temperature equal to or lower than 250° C is available for the liquid material including polysilazane. Since the curing temperature is at most 250° C, dehydrogenation does not arise in the semiconductor layer 33 that has been provided on the substrate P. Thus, rise of the on-resistance and lowering of the carrier mobility of the thin film transistor due to the dehydrogenation can be prevented.

Furthermore, it is preferable to implement residue treatment in order to remove residues of the resist (organic substance) between the banks 31a and 31b resulting from the bank formation. As a method for the residue treatment, UV irradiation treatment that implements irradiation with ultraviolet rays to remove residues, O₂ ashing treatment employing oxygen as the treatment gas in an air atmosphere, or another treatment can be selected. Here, the O₂ ashing treatment is carried out. The conditions for the ashing treatment may be the same as those for the above-described patterning of the bank 30.

### Lyophobicity Providing Treatment Step

Subsequently, lyophobicity providing treatment is implemented for the banks 31a and 31b to provide the surfaces thereof with lyophobicity. As the lyophobicity providing treatment, plasma treatment (CF₄ plasma treatment) employing tetrafluoromethane as the treatment gas in an air atmosphere can be adopted for example. If the materials of the banks 31a and 31b are the same as that of the bank 30, the conditions of the CF₄ plasma treatment may be the same as those of the plasma treatment for the bank 30. Such lyophobicity providing treatment introduces a fluorine group in resin constituting the banks 31a and 31b and thus provides the banks 31a and 31b with high lyophobicity.

The lyophobicity providing treatment for the banks 31a and 31b has some influences on the surface of the gate insulating film 83 provided with lyophilicity through the preceding residue treatment. However, introduction of a fluorine group into the gate insulating film 83 by the lyophobicity providing treatment hardly occurs, and thus the lyophilicity (wettability) of the insulating film 83 is not deteriorated. If the banks 31a and 31b are formed of a material having lyophobicity (a resin material having a fluorine group, for example), the lyophobicity providing treatment therefor may be omitted.

### Barrier Metal Film Forming Step

Subsequently, as shown in Fig. 7C, ink (liquid material) 61 for forming the barrier metal film 61a shown in Fig. 4 is applied on regions surrounded by the first and second banks 31b and 31a by using a droplet discharge method employing a droplet discharge device. Here, the ink to be discharged includes nickel fine particles as conductive fine particles and water and diethanolamine as a solvent (dispersion medium).

In the barrier metal film forming step, the ink 61 for forming the barrier metal film is discharged as droplets from the droplet discharge head 301 of the droplet discharge device IJ, so as to be disposed on regions surrounded by the first and second banks 31b and 31a. The banks 31a and 31b are provided with lyophobicity. Therefore, even when part of the discharged droplets lands on the banks, the lyophobicity of the bank surface causes the droplets to be repelled from the bank surface, and thus the dropped ink (droplets) 61 flows down into the regions surrounded by the first and second banks 31b and 31a as shown in Fig. 7C.

After the discharging and deposition of droplets of the ink for forming the barrier metal film, drying treatment is carried out if needed in order to remove the dispersion medium. The drying treatment can be implemented by heating treatment employing a typical hot plate or electric furnace for heating the substrate P, for example. In the present embodiment, heating at about 180° C for about 60 minutes is carried out for example. The heating is not necessarily carried out in an air atmosphere but may be carried out in an N₂ atmosphere for example.

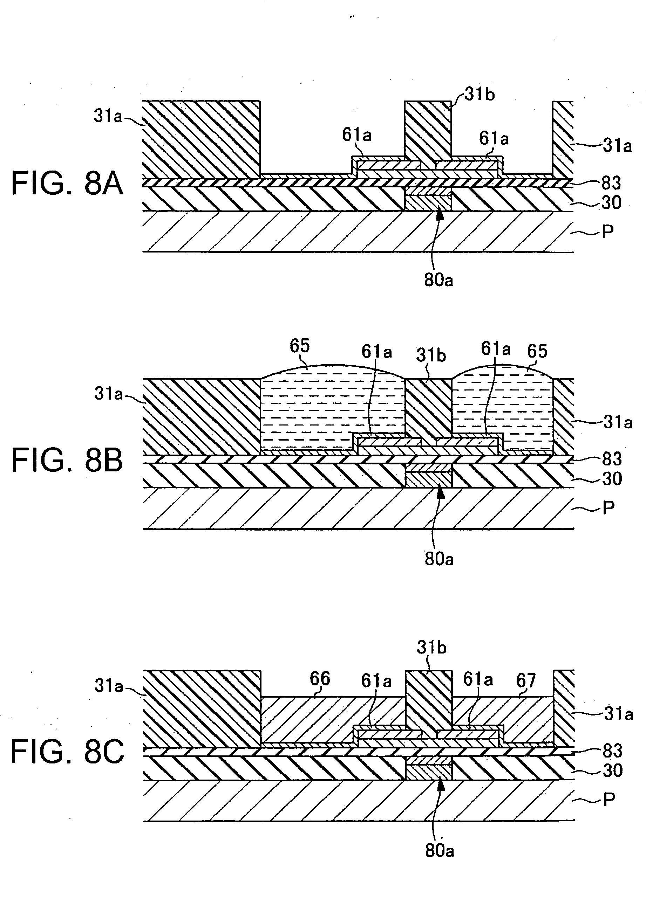

The drying treatment may be implemented by lamp annealing. Examples of light sources used in the lamp annealing may be the same as those for the intermediate drying step after the preceding first electrode layer forming step. The output power of the light sources when heating may also be in the range of 100 W to 1000 W similarly. Through this intermediate drying step, the desired barrier metal films 61a are formed over the gate insulating film 83 and the N⁺ silicon layer 85 as shown in Fig. 8A. The barrier metal films 61a constitute part of the source and drain electrodes.

### Electrode Film Forming Step

Subsequently, as shown in Fig. 8B, ink 65 for forming an electrode film is applied on the barrier metal films 61a by using a droplet discharge method employing the droplet discharge device IJ. Here, the ink to be discharged includes silver fine particles as conductive fine particles and diethylene glycol diethyl ether as a solvent (dispersion medium).

In the electrode film forming step, the ink 65 for forming an electrode film is discharged as droplets from a droplet discharge head, and the droplets are disposed on regions surrounded by the first and second banks 31b and 31a on the substrate P. The banks 31a and 31b are provided with lyophobicity. Therefore, even when part of the discharged droplets lands on the banks 31a and 31b, the lyophobicity of the bank surfaces causes the droplets to be repelled from the surfaces of the banks 31a and 31b, and thus the dropped liquid flows down into the regions.

Prior to the electrode film forming step, an intermediate layer for improving the wettability of the ink 65 may be formed on the surfaces of the barrier metal films 61 a, which have been previously formed. Mn or the like can be used as the material of the intermediate layer for example, and a droplet discharge method similar to that for the electrode films 66 and 67 can be used for the deposition thereof.

After the discharging, of the droplets, drying treatment is carried out if needed in order to remove the dispersion medium. The drying treatment can be implemented by heating treatment employing a typical hot plate or electric furnace for heating the substrate P, for example. In the present embodiment, heating at about 180° C for about 60 minutes is carried out for example. The heating is not necessarily carried out in an air atmosphere but may be carried out in an N₂ atmosphere for example.

The drying treatment may be implemented by lamp annealing. Examples of light sources used in the lamp annealing may be the same as those for the intermediate drying step after the preceding first electrode layer forming step. The output power of the light sources when heating may also be in the range of 100 W to 1000 W similarly. Through this intermediate drying step, the source and drain electrode films 66 and 67 are formed on the barrier metal films 61 a as shown in Fig. 8C.

### Cover Metal Film Forming Step

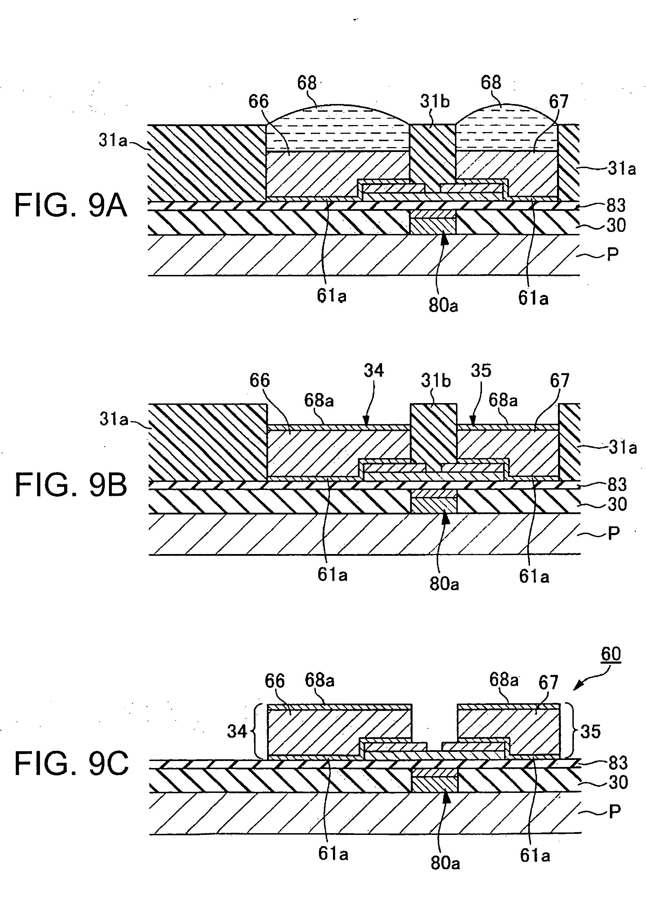

Subsequently, as shown in Fig. 9A, ink (liquid material) 68 for forming the cover metal film 68a shown in Fig. 4 is applied on regions surrounded by the first and second banks 31b and 31a (on the upper surfaces of the source and drain electrode films 66 and 67) by using a droplet discharge method employing the droplet discharge device IJ. Here, the ink to be discharged includes nickel fine particles as conductive fine particles and water and diethanolamine as a solvent (dispersion medium).

In the cover metal film forming step, the ink 68 for forming the cover metal film is discharged as droplets from the droplet discharge head 301 of the droplet discharge device IJ, so as to be disposed on regions surrounded by the first and second banks 31b and 31a. The banks 31a and 31b are provided with lyophobicity. Therefore, even when part of the discharged droplets lands on the banks, the lyophobicity of the bank surfaces causes the droplets to be repelled from the bank surfaces, and thus the dropped ink (droplets) 68 flows down into the regions.

Prior to the cover metal film forming step, an intermediate layer for improving the wettability of the ink 68 may be formed on the surfaces of the electrode films 66 and 67, which have been previously formed. A thin film including titanium oxide can be used as the intermediate layer for example, and a droplet discharge method similar to that for the cover metal film 68a can be used for the deposition thereof.

After the discharging of droplets of the ink for forming an electrode, drying treatment is carried out if needed in order to remove the dispersion medium. The drying treatment can be implemented by heating treatment employing a typical hot plate or electric furnace for heating the substrate P, for example. In the present embodiment, heating at about 180° C for about 60 minutes is carried out for example. The heating is not necessarily carried out in an air atmosphere but may be carried out in an N₂ atmosphere for example.

The drying treatment may be implemented by lamp annealing. Examples of light sources used in the lamp annealing may be the same as those for the intermediate drying step after the preceding first electrode layer forming step. The output power of the light sources when heating may also be in the range of 100 W to 1000 W similarly. Through this intermediate drying step, the cover metal films 68a are formed on the source and drain electrode films 66 and 67 as shown in Fig. 9B. These cover metal films 68a constitute part of the source and drain electrodes.

### Baking Step

The dispersion medium needs to be completely removed from the dried film obtained after the discharging step, in order to enhance electric contact among the fine particles. In addition, if the surfaces of the conductive fine particles are coated with a coating agent, such as an organic substance, to enhance the dispersibility of the particles, this coating agent also needs to be removed. Therefore, heat treatment and/or light treatment are implemented for the substrate after the discharging step.

The heat treatment and/or light treatment are typically carried out in an air atmosphere. If necessary, the treatment may also be carried out in an inactive gas atmosphere, such as a nitrogen, argon, or helium atmosphere. The treatment temperature for the heat treatment and/or light treatment is appropriately determined with taking into consideration the boiling point (vapor pressure) of the dispersion medium, the kind and pressure of the atmospheric gas, the dispersibility, oxidizability and other thermal behaviors of the fine particles, the presence and volume of the coating agent, the heat resistance temperature of the base material, and so on.

In the present embodiment, the multi-layer structure of the source and drain electrodes 34 and 35 are composed of the above-described metal materials. Therefore, the heat treatment of the baking step can be implemented at a temperature equal to or lower than 250° C. Specifically, even through heating at a temperature equal to or lower than 250° C, electrode members having favorable conductivity can be formed. This heating temperature prevents the thin film transistor from suffering rise of the on-resistance and lowering of the carrier mobility due to dehydrogenation in the semiconductor layer 33. Thus, the operational reliability of the formed thin film transistor can be maintained.

Through the above step, electric contact among the fine particles is ensured in the dried film obtained after the discharging step, which turns the dried film into a conductive film. As a result, the source and drain electrodes 34 and 35 of a three-layer structure are formed on the glass substrate P. In addition, the data lines 18a integrated with the source electrodes 34 are also formed on the glass substrate P through the above steps as shown in Fig. 3.

It is preferable that, after the baking step, the thicknesses of the barrier metal film 61 a and the cover metal film 68a be in the range of about 20 nm to 400 nm, and the thicknesses of the electrode films 66 and 67 be in the range of about 500 nm to 1500 nm. A thickness under 20 nm of the barrier metal film 61a cannot sufficiently prevent diffusion of the metal atoms from the electrode films 66 and 67 into the semiconductor layer 33. In addition, a thickness over 400 nm increases the resistance of the source electrode 34 (and the data line 16) and the drain electrode 35. Furthermore, a thickness under 20 nm of the cover metal film 68a cannot sufficiently prevent diffusion of the metal atoms from the electrode films 66 and 67 into the bank 31c (refer to Fig. 4) and the liquid crystal layer. In addition, a thickness over 400 nm increases the resistance of the source electrode 34 (and the data line 16) and the drain electrode 35.

In the above steps, the electrode films 66 and 67 composed of Ag are formed as the base layer, the barrier metal film 61 a composed of Ni is formed as the barrier layer, and the cover metal film 68a composed of Ni is formed as the cover layer. However, the metals constituting these metal films are not limited to Ag and Ni. The electrode films 66 and 67 may be composed of Cu, Al or an alloy based on these metals, for example. Furthermore, the barrier metal film 61a and the cover metal film 68a may be composed of Ti, W, Mn, or an alloy based on these metals.

### Bank Removal Step

Subsequently, of the banks provided over the glass substrate P, the first and second banks 31b and 31a are selectively removed. In the removal step, the banks 31a and 31b are removed by ashing treatment, such as plasma ashing or ozone ashing. The plasma ashing is a method to make the bank react with a gas changed into plasma, such as an oxygen gas, to thereby vaporize and remove the bank. In addition, the ozone ashing is a method to decompose ozone (O₃) into active oxygen and make the active oxygen react with the bank, to thereby vaporize and remove the bank. Through the bank removal step, the thin film transistor (TFT) 60 formed on the glass substrate P can be obtained as shown in Fig. 9C.

### Pixel Electrode Forming Step

Subsequently, the pixel electrodes 19 shown in Fig. 4 are formed on the glass substrate P on which the TFTs 60 have been formed. The pixel electrode forming step includes a bank forming step, a lyophobicity providing treatment step, a liquid material deposition step, and a baking step.

### Bank Forming Step

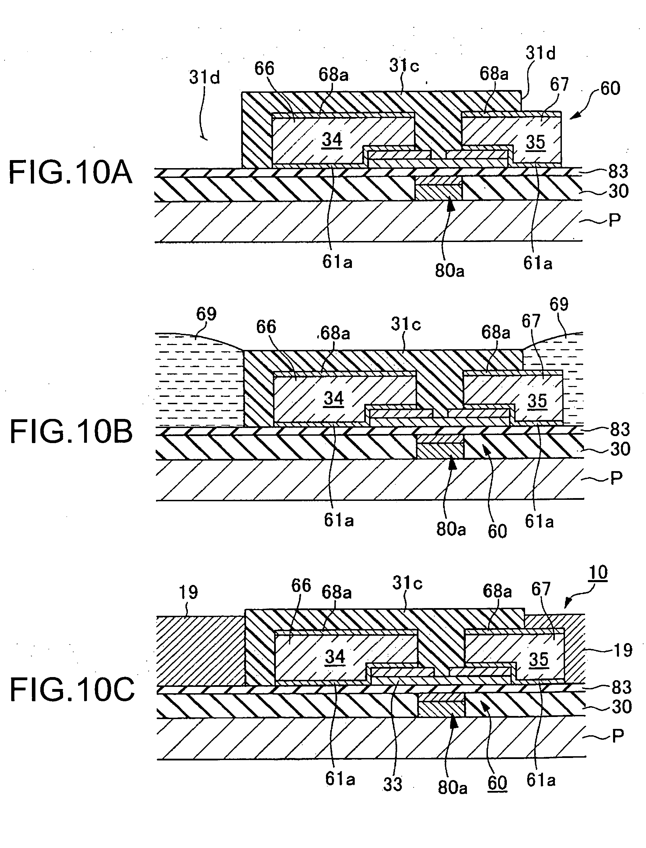

As shown in Fig. 10A, a bank for forming the pixel electrode 19 is formed on a certain position on the substrate P. The bank 31 c is formed to partly cover the TFT 60 as shown in Figs. 10A to 10C, and is formed in a substantially grid shape surrounding the pixel electrodes 19 shown in Fig. 4 in plan view. The bank can be formed with any method, such as photolithography or printing. When using photolithography for example, an organic photosensitive material based on acrylic resin is applied to a height corresponding to the height of the bank to be formed by a certain method such as spin coating, spray coating, roll coating, die coating or dip coating, to thereby form a photosensitive material layer. Thereafter, the photosensitive material layer is irradiated with ultraviolet rays according to the shape of the bank to be formed.

The bank 31c is patterned so that, of the constitutional elements of the TFT 60, the drain electrode 35 projects into the region surrounded by the bank 31c. Since the cover metal film 68a is formed on the surface of the drain electrode 35 that has been provided on the substrate P, it can be prevented that an etchant enters and erodes the electrode film 67 in the patterning of the bank 31c.

The bank 31c may be an inorganic structure formed by using a liquid material including polysilazane or the like. In the case of forming banks composed of an inorganic material, a heating temperature for curing the banks is often higher compared with the case of forming banks by using an organic material such as a resin material. However, using the above material can allow a temperature for curing the bank 31 c equal to or lower than 250° C. Thus, dehydrogenation in the semiconductor layer 33 can be prevented effectively, to thereby prevent rise of the on-resistance and lowering of the carrier mobility of the formed thin film transistor.

Furthermore, it is preferable to implement residue treatment in order to remove residues of the resist (organic substance) on the region surrounded by the bank 31 c resulting from the bank formation. As a method for the residue treatment, UV irradiation treatment that implements irradiation with ultraviolet rays to remove residues, O₂ ashing treatment employing oxygen as the treatment gas in an air atmosphere, or another treatment can be selected. Here, the O₂ ashing treatment is carried out. The conditions for the ashing treatment may be the same as those for the above-described patterning of the bank 30.

### Lyophobicity Providing Treatment Step

Subsequently, lyophobicity providing treatment is implemented for the bank 31c to provide the surface thereof with lyophobicity. The lyophobicity providing treatment can employ a treatment method similar to that of the above-described lyophobicity providing treatment.

The lyophobicity providing treatment for the bank 31c has some influences on the surface of the gate insulating film 83 provided with lyophilicity through the preceding residue treatment. However, introduction of a fluorine group into the gate insulating film 83 by the lyophobicity providing treatment hardly occurs, and thus the lyophilicity (wettability) of the insulating film 83 is not deteriorated. If the bank 31c is formed of a material having lyophobicity (a resin material having a fluorine group, for example), the lyophobicity providing treatment therefor may be omitted.

### Liquid Material Deposition Step

Subsequently, as shown in Fig. 10B, ink (liquid material) for forming the pixel electrode is applied on the region surrounded by the bank 31c by using a droplet discharge method employing the droplet discharge device IJ. Here, ink is discharged that includes fine particles of an optical transparent conductive material, such as ITO, IZO or FTO, dispersed in a solvent (dispersion medium).

The present embodiment uses a liquid material for forming an optical transparent conductive film that can achieve favorable optical transparency and conductivity even if a baking temperature therefor is equal to or lower than 250° C. Examples of such a liquid material include one having ITO fine particles and a silicon organic compound, and one having ITO fine particles, an indium organic compound and a tin organic compound. Using any of these liquid materials allows formation of an optical transparent conductive film having a structure in which the ITO fine particles are tightly bonded to each other in a matrix of SiO₂ or ITO produced from the silicon or metal organic compound. Thus, even through a low baking temperature, an optical transparent conductive film can be formed in which the ITO fine particles are closely disposed and favorable conductivity among the fine particles is achieved.

In the pixel electrode forming step, the ink 69 including a pixel electrode forming material is discharged as droplets from the droplet discharge head 301 of the droplet discharge device IJ, so as to be disposed in the region surrounded by the bank 31 c. The bank 31 c is provided with lyophobicity. Therefore, even when part of the discharged droplets lands on the bank, the lyophobicity of the bank surface causes the droplets to be repelled from the bank surface, and thus the dropped ink (droplets) 69 flows down into a region 31d surrounded by the bank 31c as shown in Fig. 10B.

After the discharging of droplets of the ink for forming an electrode, drying treatment is carried out if needed in order to remove the dispersion medium. The drying treatment can be implemented by heating treatment employing a typical hot plate or electric furnace for heating the substrate P, for example. In the present embodiment, heating at about 180° C for about 60 minutes is carried out for example. The heating is not necessarily carried out in an air atmosphere but may be carried out in an N₂ atmosphere for example.

The drying treatment may be implemented by lamp annealing. Examples of light sources used in the lamp annealing may be the same as those for the intermediate drying step after the preceding first electrode layer forming step. The output power of the light sources when heating may also be in the range of 100 W to 1000 W similarly. This intermediate drying step forms the desired pixel electrode 19 as shown in Fig. 10C.

### Baking Step

The dispersion medium needs to be completely removed from the dried film obtained after the discharging step, in order to enhance electric contact among the fine particles. In addition, if the surfaces of the conductive particles are coated with a coating agent, such as an organic substance, to enhance the dispersibility of the particles, this coating agent also needs to be removed. Therefore, heat treatment and/or light treatment are implemented for the substrate after the discharging step.

The heat treatment and/or light treatment are typically carried out in an air atmosphere. If necessary, the treatment may also be carried out in an inactive gas atmosphere, such as a nitrogen, argon, or helium atmosphere. The treatment temperature for the heat treatment and/or light treatment is appropriately determined with taking into consideration the boiling point (vapor pressure) of the dispersion medium, the kind and pressure of the atmospheric gas, the dispersibility, oxidizability and other thermal behaviors of the fine particles, the presence and volume of the coating agent, the heat resistance temperature of the base material, and so on.

In the present embodiment, the pixel electrode 19 is formed of the liquid material with the above-described composition. Therefore, the heat treatment of the baking step can be implemented at a temperature equal to or lower than 250° C. This heating temperature can favorably prevent the thin film transistor from suffering rise of the on-resistance and lowering of the carrier mobility due to dehydrogenation in the semiconductor layer 33. Thus, the operational reliability of the formed thin film transistor can be maintained.

As another liquid material for forming an optical transparent conductive film that can achieve favorable optical transparency and conductivity even if a baking temperature is equal to or lower than 250° C, one including ITO fine particles and an Si precursor, and one including ITO fine particles and an ITO precursor can be exemplified. Using any of these liquid materials allows formation of an optical transparent conductive film having a structure in which the ITO fine particles are tightly bonded to each other in a matrix of SiO₂ or ITO produced from the precursor. Thus, even through a low baking temperature, an optical transparent conductive film can be formed in which the ITO fine particles are closely disposed and favorable conductivity among the fine particles is achieved.

Through the above step, electric contact among the fine particles is ensured in the dried film obtained after the discharging step, which turns the dried film into a conductive film. As a result, the pixel electrodes 19 are formed on the substrate P, and thus the TFT array substrate 10 having the thin film transistors shown in Fig. 4 can be manufactured.

In addition, according to the manufacturing method of the present embodiment, heating temperatures of the heat treatment after the formation of the semiconductor layer 33 over the glass substrate P are equal to or lower than 250° C. Therefore, dehydrogenation in the semiconductor layer 33 can be prevented effectively. Thus, rise of the on-resistance and lowering of the carrier mobility can be prevented. Accordingly, the TFTs 60 having excellent operational reliability and the TFT array substrate 10 of high reliability can be achieved.

In the embodiment, the barrier metal film 61a, the electrode films 66 and 67, and the cover metal film 68a are simultaneously baked to form the source and drain electrodes 34 and 35. In contrast, each metal film may be baked sequentially. Specifically, after the barrier metal film 61a has been baked, ink for forming the electrode films 66 and 67 may be discharged and deposited to form the electrode films. In addition, after the electrode films 66 and 67 have been baked, ink for forming the cover metal film 61a may be discharged and deposited. In this case, the metal films that have been provided over the substrate P have improved stability against the solvents (dispersion mediums).

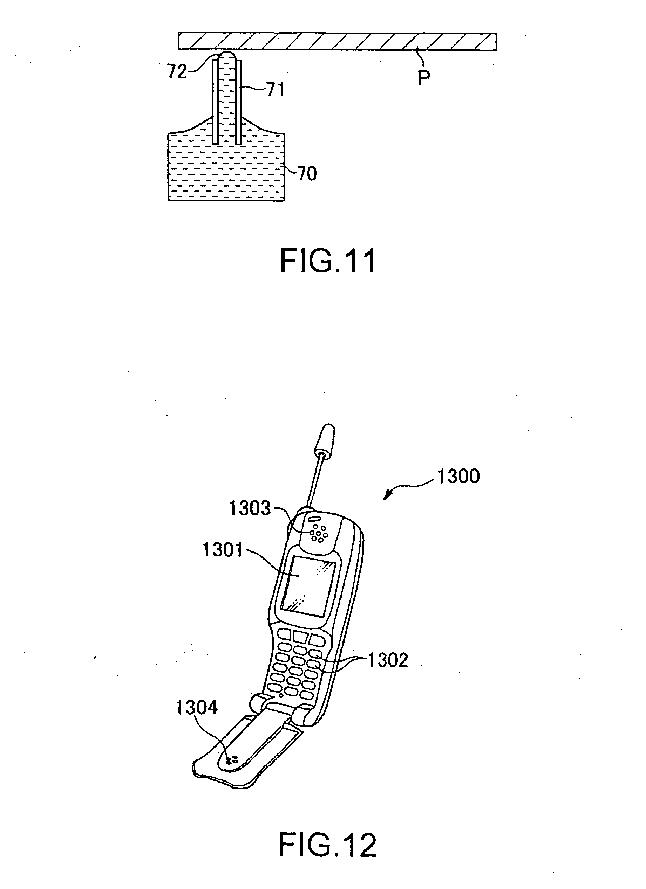

Although the embodiment adopts a droplet discharge method employing a droplet discharge device to deposit droplets (liquid material), another method, such as a Cap coating method shown in Fig. 11, can be adopted for example. The Cap coating method is a film deposition method utilizing a capillary phenomenon. In the Cap coating method, a slit 71 is inserted into a liquid 70 to be applied. Rising the liquid surface in this state generates a liquid raise 72 at the upper tip of the slit 71. Bringing the substrate P into contact with the liquid raise 72 and horizontally moving the substrate P in a certain direction enables the liquid 70 to be applied on the substrate P.

The method of manufacturing a thin film transistor described in the embodiments can be applied to manufacturing methods of various electro-optical devices including thin film transistors. For example, the method can preferably be applied to forming of thin film transistors included in liquid crystal devices, organic electroluminescence displays and plasma displays.

### Electronic Apparatus

Fig. 12 is a perspective view illustrating an example of an electronic apparatus according to an embodiment of the invention. Referring to Fig. 12, a cellular phone 1300 includes the liquid crystal display of the embodiment of the invention as a small size display part 1301, and further includes a plurality of operation buttons 1302, a earpiece 1303, and a mouthpiece 1304.

The electro-optical device according to the embodiment can be used not only as an image display unit of cellular phones, but also as that of electronic books, personal computers, digital still cameras, video monitors, video tape recorders of viewfinder types or monitor viewing types, car navigation devices, pagers, electronic notebooks, electric calculators, word processors, work stations, picture phones, point-of-sale (POS) terminals, apparatuses equipped with a touch panel, and so on. Such electronic apparatuses are inexpensive yet have excellent reliability.

## Claims

1. A thin film transistor comprising:
a semiconductor layer formed over a substrate; and
an electrode member formed over the substrate by a liquid phase method,
wherein:
the electrode member includes a base layer composed of a metal material and an outer surface layer deposited on at least one surface of the base layer; and
the outer surface layer is formed of a metal material that is less susceptible to being dissolved in silicon and a silicon compound compared with the metal material constituting the base layer.

2. A thin film transistor comprising:
a semiconductor layer formed over a substrate; and
an electrode member formed over the substrate, wherein:
the electrode member has a structure in which a barrier layer and a base layer are sequentially deposited on top of each other by using a liquid phase method, the barrier layer being composed of a metal material, the base layer being composed of a metal material; and
the metal material constituting the barrier layer is at least one metal material selected from Ni, Ti, W and Mn.

3. The thin film transistor according to claim 1, wherein the metal material constituting the base layer is at least one metal material selected from Ag, Cu and Al.

4. The thin film transistor according to claim 1, wherein:
part of the electrode member is a source electrode and a drain electrode that are electrically coupled to the semiconductor layer; and
the source electrode and/or the drain electrode have a multi-layer structure of a barrier layer and the base layer.

5. A thin film transistor comprising:
a semiconductor layer formed over a substrate; and
an electrode member formed over the substrate, wherein:
the electrode member has a structure in which a base layer and a cover layer are sequentially deposited on top of each other by using a liquid phase method, the base layer being composed of a metal material, the cover layer being composed of a metal material; and
the metal material constituting the cover layer is at least one metal material selected from Ni, Ti, W and Mn.

6. The thin film transistor according to claim 5, wherein the metal material constituting the base layer is at least one metal material selected from Ag, Cu and Al.

7. The thin film transistor according to claim 5, wherein:
the thin film transistor is a bottom-gate thin film transistor that includes a gate electrode formed between the semiconductor layer and the substrate; and
the gate electrode has a multi-layer structure of the base layer and the cover layer.

8. The thin film transistor according to claim 5, wherein:
part of the electrode member is a source electrode and a drain electrode that are electrically coupled to the semiconductor layer; and
the source electrode and/or the drain electrode have a multi-layer structure of the base layer and the cover layer.

9. The thin film transistor according to claim 1, wherein the thin film transistor is subjected to heat treatment at a temperature equal to or lower than 250° C at least after the semiconductor layer has been formed.

10. An electro-optical device comprising the thin film transistor according to claim 1.

11. An electronic apparatus comprising the electro-optical device according to claim 10.
